# EUROPEAN PATENT SPECIFICATION

(11) **EP 1 762 338 B1**
(45) Date of publication and mention of the grant of the patent: **01.07.2009**
(21) Application number: 06254695.7
(22) Date of filing: 08.09.2006
(51) Int. Cl.: B24B 37/04, B24B 53/013, B24D 3/32

(54) **Abrasive member and method for the resurfacing of a lapping plate**
Schleifelement und Verfahren zum Flachschleifen einer Läppscheibe
Elément abrasif et procédé pour resurfaçage d'un plateau de rodage

(30) Priority: 08.09.2005 JP 2005260526
(43) Date of publication of application: 14.03.2007
(73) Proprietor: Shinano Electric Refining Co., Ltd., Chiyoda-ku, Tokyo (JP)
(72) Inventor: Yasuoka, Kai c/o Shinano Electric Refining Co,Ltd, Chiyoda-ku, Tokyo (JP); Kazama, Kenichi, c/o Shinano Electric Refining Co.,Ltd., Chiyoda-ku, Tokyo (JP); Tsuneya, Ayumi, c/o Shinano Electric Refining Co.,Ltd., Chiyoda-ku, Tokyo (JP); Sato, Shunji, c/o Shinano Electric Refining Co.,Ltd., Chiyoda-ku, Tokyo (JP)
(74) Representative: Stoner, Gerard Patrick

(56) References cited:
- EP-A- 1 535 701
- WO-A1-03/082519
- WO-A2-02/15247
- AU-A- 1 020 070
- GB-A- 1 226 780
- GB-A- 2 360 725
- JP-A- 2000 218 521
- US-A- 6 102 784

## Description

This invention generally relates to a lapping machine, as per the preamble of claim 1, comprising a lapping plate, and a workpiece carrier with a workpiece-holding hole disposed on the plate, a workpiece being fitted within the hole in the carrier, wherein the workpiece is lapped while the plate and the carrier are individually rotated, and loose abrasive grains are fed to the plate. More particularly, it relates to a method for regulating (or resurfacing) the surface of the lapping plate.

An example of such a lapping machine and such a regulating method is disclosed by JP 2000 218 521 A.

### BACKGROUND

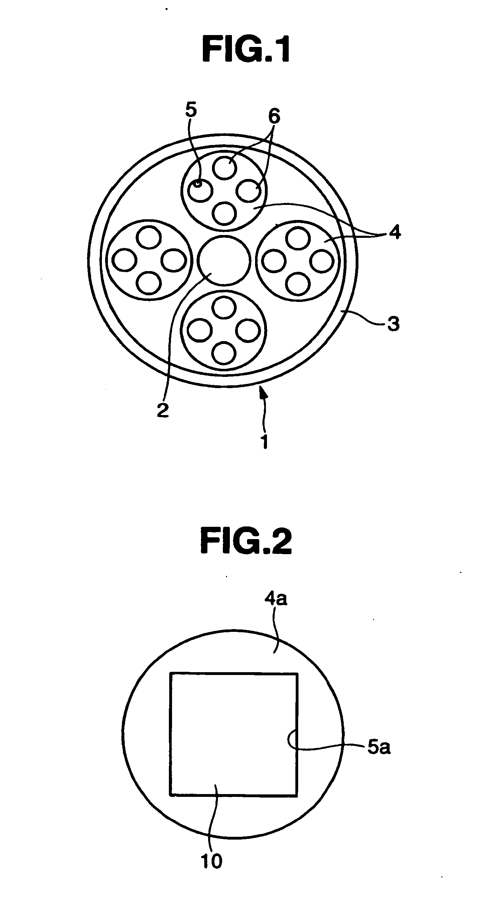

In the prior art, a lapping machine as shown in FIG. 1 is used for lapping workpieces such as silicon wafers, synthetic quartz glass, rock crystal, liquid crystal glass, and ceramics. The machine of FIG. 1 includes a low< drive (not shown). On the inner diameter side of the plate, a sun gear 2 is disposed at the center. An annular or internal gear 3 is disposed along the outer periphery of the plate 1. A plurality of carriers 4 are disposed in mesh engagement with the gears 2 and 3. Each carrier 4 is provided with workpiece-holding holes 5. A workpiece 6 is fitted within each holding hole 5. Above the carriers 4, an upper lapping plate may be disposed for rotation like the lower lapping plate 1, though not shown. When the plate 1 is rotated, the carriers 4 are rotated counter to the plate rotation. Then, the workpieces 6 are lapped with loose abrasive grains fed to the plate as the workpieces revolve about the gear 2 and rotate about their own axes.

As polishing and lapping steps are repeated using the lapping machine described above, the plate is worn to assume a convex or irregular shape. Once the plate is worn to such a shape, a plate-dressing jig made of the same cast iron material as the plate is used to true the plate surface for flatness while loose abrasive grains are fed thereto. After the plate is dressed in this way, it can be used again to repeat polishing and lapping steps in a similar manner. Known plate-dressing jigs used in the art for dressing the surface accuracy of the plate of the lapping machine for carrying out polishing and lapping steps include those described in JP-A 2000-135666 and JP-A 2000-218521.

EP 1 535 701 A1 describes a process for producing a polyurethane grinding tool having a Rockwell hardness (HRS) in the range of -55 to -100 for polishing the surface of gravure printing rolls by mixing an organic polyisocyanate with inorganic abrasive grains.

Although these plate-dressing jigs are effective for dressing the lapping plates for flatness, they are ineffective in increasing the efficiency of lapping operation. It would be desirable to have a method of carrying out more efficient lapping operation.

An object of the invention is to provide a plate resurfacing apparatus and method using a lapping plate resurfacing abrasive member which can recondition a lapping plate surface so as to increase the loose abrasive grain holding force of the plate for thereby improving its lapping force, and provide the plate with a uniform rough surface for imparting to the plate a surface state capable of developing a stable constant lapping force during the operation from immediately after resurfacing.

The inventors have found that when a lapping plate is regulated for surface roughness by using a synthetic resin-based elastic abrasive member having a Rockwell hardness (HRS) in the range of -30 to -100, especially a porous synthetic resin-based elastic abrasive member having a large number of microscopic cells in the interior, and feeding loose abrasive grains which are the same as loose abrasive grains to be fed onto the plate when a workpiece such as silicon wafers, synthetic quartz glass, rock crystal, liquid crystal glass, and ceramics is lapped, the plate surface is regulated (or resurfaced) to a surface roughness which is about 1.5 to 3 times rougher than the surface roughness of a plate reached when the plate surface is dressed by using a plate-dressing jig made of ceramics, metals or the like such as a dressing ring and feeding the same abrasive grains. Then, when a workpiece is actually lapped using the resurfaced plate together with loose abrasive grains, the resurfaced plate on its surface has an increased abrasive grain holding force and hence, an improved finishing force. This reduces the lapping time and enables efficient lapping of the workpiece. The machining force is constant throughout the lapping operation even from the initial operation after the resurfacing, and the workpiece can be given a stable uniform finish surface, and the lapping force is stabilized. In these regards too, the lapping process becomes more efficient.

The invention pertains to a lapping machine comprising a lapping plate, and a workpiece carrier with a workpiece-holding hole disposed on the plate, a workpiece being fitted within the hole in the carrier, wherein the workpiece is lapped while the plate and the carrier are individually rotated and loose abrasive grains are fed onto the plate.

In another aspect, the invention provides a method for resurfacing a lapping plate, comprising the steps of placing a resurfacing carrier with a holding hole on the lapping plate, holding within the carrier hole a synthetic resin-based elastic abrasive member having a Rockwell hardness (HRS) in the range of -30 to -100, rotating the plate and the carrier individually, and feeding loose abrasive grains onto the plate, for thereby lapping the surface of the plate with the elastic abrasive member for roughening the plate surface in accordance with the coarseness of the abrasive grains.

Preferably, the abrasive grains are the same as loose abrasive grains to be fed onto the plate when a workpiece is lapped. Also preferably, the synthetic resin-based elastic abrasive member is porous. More preferably, the elastic abrasive member is a polyurethane or polyvinyl acetal-based abrasive member having a large number of microscopic cells. More preferably, the elastic abrasive member has a bulk density of 0.4 to 0.9 g/cm³. Typically, the elastic abrasive member has abrasive grains dispersed and bound therein which are the same as loose abrasive grains to be fed onto the plate when a workpiece is lapped.

Often, the workpiece is selected from among silicon wafers, synthetic quartz glass, rock crystal, liquid crystal glass, and ceramics.

### BENEFITS

According to the invention, workpieces such as silicon wafers, synthetic quartz glass, rock crystal, liquid crystal glass, and ceramics can be efficiently lapped. The invention is thus effective in reducing the time and cost of lapping. Workpieces as lapped have a surface roughness with minimal variations, indicating the delivery of workpieces of consistent quality.

### BRIEF DESCRIPTION OF THE DRAWINGS

FIG. 1 is a plan view of a workpiece lapping machine with an upper plate removed.
FIG. 2 is a plan view of an exemplary resurfacing carrier.
FIG. 3 schematically illustrates the surface of a plate which has been lapped using an abrasive member of the invention.
FIG. 4 schematically illustrates the surface of a plate which has been dressed and lapped using a plate-dressing jig.
FIG. 5 is a schematic cross-sectional view of a plate which has been lapped using an elastic abrasive member.
FIG. 6 is a schematic cross-sectional view of a plate which has been lapped using a non-elastic abrasive member.
FIG. 7 is a graph showing depth of material removal versus batch number when silicon wafers are lapped in Example I and Comparative Example I.
FIG. 8 is a graph showing depth of material removal versus batch number when synthetic quartz glass substrates are lapped in Example II and Comparative Example II.
FIG. 9 is a graph showing surface roughness versus batch number in Example II and Comparative Example II.
FIG. 10 is a graph showing depth of material removal when plates are lapped using different abrasive members in Reference Example.
FIG. 11 is a graph showing surface roughness in the same test as in FIG. 10.
FIG. 12 is a photomicrograph of plate resurfacing abrasive member No. 1.
FIG. 13 is a photomicrograph of plate resurfacing abrasive member No. 2.

### FURTHER EXPLANATIONS; OPTIONS AND PREFERENCES

The terms "a" and "an" herein do not denote a limitation of quantity, but rather denote the presence of at least one of the referenced item. The term "abrasive member" is exchangeable with lapping wheel or grinding tool or grindstone. The term "resurfacing" means that the surface of a lapping plate is regulated or conditioned to an appropriate roughness rather than to a certain flatness.

The lapping plate resurfacing abrasive member of the invention comprises an elastic abrasive member made of synthetic resin. The elastic abrasive member used herein is preferably selected from porous elastic abrasive members having a large number of microscopic cells in its interior and made of thermosetting resins, and especially porous elastic abrasive members having a large number of microscopic cells in its interior and made of polyvinyl acetal or polyurethane. Examples of the thermosetting resin include, but are not limited to, polyvinyl acetal resins, phenolic resins, melamine resins, urea resins, acrylic resins, methacrylic resins, epoxy resins, polyester resins, and polyurethane resins, which may be used alone or in admixture.

Abrasive members made of materials comprising polyvinyl acetal are preferred for hardness and wear. Preferred polyvinyl acetal-based elastic abrasive members are those made of mixtures of a polyvinyl acetal resin and another thermosetting resin. The mixtures preferably consist of 10 to 35 parts by weight of polyvinyl acetal resin and 5 to 20 parts by weight of the other thermosetting resin. Outside the range, a smaller proportion of polyvinyl acetal resin results in an abrasive member which may include a less proportion of porous moiety, lose elasticity and have a higher hardness whereas a smaller proportion of the other thermosetting resin may adversely affect a binding force between the porous moiety of polyvinyl acetal resin and fine abrasive grains, resulting in an abrasive member with a lower hardness.

As mentioned above, the polyvinyl acetal-based elastic abrasive member should preferably be a porous one having a large number of microscopic cells. One typical means for rendering the abrasive member porous is the previous addition of a cell-forming agent such as corn starch during the polyvinyl acetal resin preparing process. After the acetal-forming reaction, the cell-forming agent is washed away whereby those portions where the cell-forming agent has been present during the reaction are left as cells in the resulting abrasive member.

Also abrasive members made of polyurethane are advantageously used. Polyurethanes are typically prepared through reaction of polyether and/or polyester polyols with organic isocyanates. Suitable polyol components include polyether polyol, diethylene glycol, triethylene glycol, dipropylene glycol, and tripropylene glycol. Suitable organic isocyanates include 4,4'-diphenylmethane diisocyanate and tolylene 2,4-diisocyanate.

Likewise, the polyurethane-based abrasive members are preferably porous. Suitable means for rendering the abrasive member porous include the addition of known blowing agents such as water and the entrapment of air by agitation during the curing reaction.

The porous abrasive member may have either open or closed cell structure, and the cells preferably have a diameter of 30 to 150 µm.

In the synthetic resin-based elastic abrasive member, fine abrasive grains are preferably incorporated. The amount of abrasive grains incorporated is preferably 30 to 70% by weight, more preferably 40 to 60% by weight, based on the total weight of the abrasive member. The abrasive grains preferably have an average grain size of about 40 µm to about 1 µm. As to the material, abrasive grains may be made of silicon carbide, alumina, chromium oxide, cerium oxide, zirconium oxide, zircon sand or the like, alone or in admixture. Preferred are abrasive grains which are identical in material and grain size with the loose abrasive grains that are used in lapping workpieces with lapping plates after the plates are resurfaced according to the invention.

In the embodiment wherein abrasive grains are compounded in resin, the resulting abrasive member has abrasive grains dispersed and bound therein, and thus becomes more efficient in plate resurfacing. In the preferred embodiment wherein abrasive grains which are the same as loose abrasive grains used in workpiece lapping are dispersed and bound in the abrasive member, no problems arise after a plate is resurfaced using this abrasive member. That is, even if some abrasive grains are removed from the abrasive member and left on the plate surface, the trouble that the remaining abrasive grains cause scratches to workpieces is avoided because they are the same as loose abrasive grains used in workpiece lapping.

The synthetic resin-based elastic abrasive member should have a Rockwell hardness (HRS) in the range of -30 to -100, and especially in the range of -50 to -80. Outside the range, too low a Rockwell hardness allows the abrasive member to be worn much during lapping, which is uneconomical. With too high a Rockwell hardness, the elastic abrasive member loses the characteristic spring effect and fails in uniformly resurfacing the plate surface. The Rockwell hardness is a measurement on the HRS scale including a test load of 100 kg and a steel ball indenter with a diameter of 1/2 inch.

As mentioned above, the preferred elastic abrasive member is a porous abrasive member having a large number of microscopic cells in the interior. In this preferred embodiment, the cells preferably have a diameter of 30 to 150 µm, more preferably 40 to 100 µm. If the cell diameter is less than 30 µm, the abrasive member may have less elasticity, losing the spring effect. If the cell diameter is more than 150 µm, the spring effect is readily available, but the abrasive member structure becomes coarse and can be worn much, which is uneconomical. The elastic abrasive member preferably has a bulk density of 0.4 to 0.9 g/cm³, and more preferably 0.5 to 0.7 g/cm³. If the bulk density is too low, the abrasive member has a coarse structure, becomes brittle as a whole, and can break during the lapping operation. If the bulk density is too high, the abrasive member has an over-densified structure, lowing the spring effect due to elasticity.

It is noted that the shape of the abrasive member is not particularly limited and it may be formed to any planar shapes including circular and regular polygonal shapes such as square, hexagonal and octagonal shapes. Its thickness is preferably about 10 mm to about 75 mm.

The time when a lapping plate is resurfaced using the resurfacing abrasive member in the form of an elastic abrasive member is not particularly limited. The resurfacing abrasive member of the invention is not effective in dressing raised portions or raised and recessed portions on the plate surface, created during the service of the plate, for flattening the plate surface. In such a case, preferably a conventional dressing jig is used to dress the plate surface, before the abrasive member of the invention is used for resurfacing.

When resurfacing of a lapping plate is carried out using the plate resurfacing abrasive member of the invention, there is first furnished a regulatory carrier with an elastic abrasive member holding hole. The elastic abrasive member is held within the carrier hole. At this point, if the abrasive member has an appropriate planar shape to fit within a workpiece holding hole in a carrier as shown in FIG. 1, that is, the same shape as the workpiece, this carrier can be used directly as the regulatory carrier, and if so, the abrasive member is fitted within the workpiece holding hole. If the abrasive member has a different shape from the workpiece, there is furnished a regulatory carrier with a holding hole of the same planar shape as the abrasive member, and the abrasive member is fitted within this holding hole. For example, if the abrasive member is square in planar shape, a regulatory carrier 4a with a square shaped holding hole 5a as shown in FIG. 2 is furnished, and a plate resurfacing abrasive member 10 is fitted within the hole 5a. In the arrangement shown in FIG. 1, for example, the regulatory carrier 4a is incorporated in the lapping machine in place of the carrier 4 whereupon the plate surface is lapped while feeding loose abrasive grains onto the plate as in the ordinary lapping of workpieces. The regulatory carrier is desirably made of the same material as the workpiece holding carrier or the lapping plate because this avoids the entry of any foreign material. Usually, the carriers are made of iron, cast iron, epoxy resins, vinyl chloride resins or the like.

The lapping conditions for resurfacing may be selected as appropriate although they are preferably selected to be identical with the lapping conditions under which workpieces are lapped after the resurfacing.

When the lapping treatment of the plate is conducted by the elastic abrasive member, it is preferred to use loose abrasive grains which are the same as the loose abrasive grains used in the subsequent lapping of workpieces. This is convenient in that even if some loose abrasive grains are left on the plate after the lapping treatment of the plate by the elastic abrasive member, the remaining abrasive grains do not disturb the subsequent lapping of workpieces.

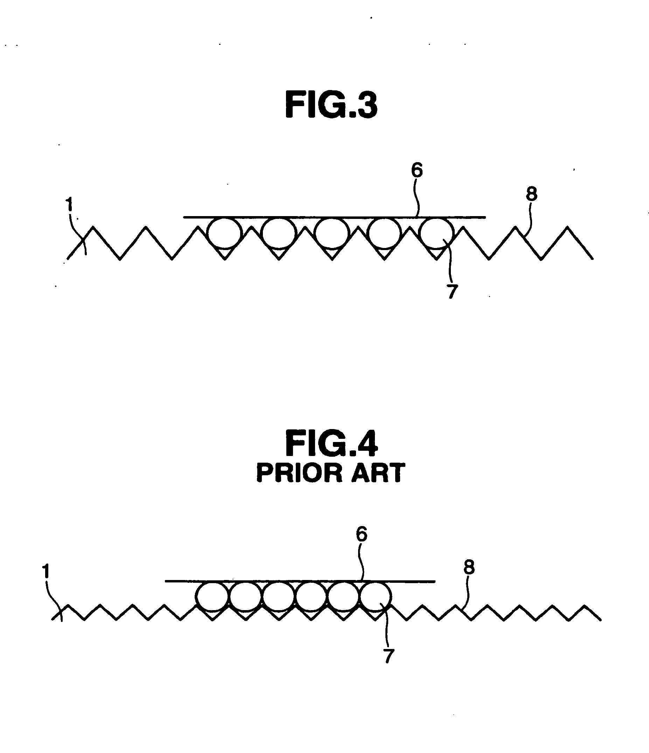

When the lapping treatment of the plate is conducted by the synthetic resin-based elastic abrasive member, the plate surface is roughened depending on the material, grain size and other parameters of loose abrasive grains. We find that the plate surface is regulated to a surface roughness which is about 1.5 to 3 times rougher than the surface roughness of a plate reached when the plate surface is dressed by using a plate-dressing jig made of the same material as the plate, like cast iron, ceramics or electroplated diamond, and feeding the same loose abrasive grains. This difference is readily understood by referring to FIGS. 3 and 4. FIG. 3 schematically illustrates the surface state of a plate 1 which has been lapped using an elastic abrasive member of the invention. In contrast, FIG. 4 schematically illustrates the surface state of a plate 1 which has been lapped using a plate-dressing jig or ring made of the same cast iron as the plate.

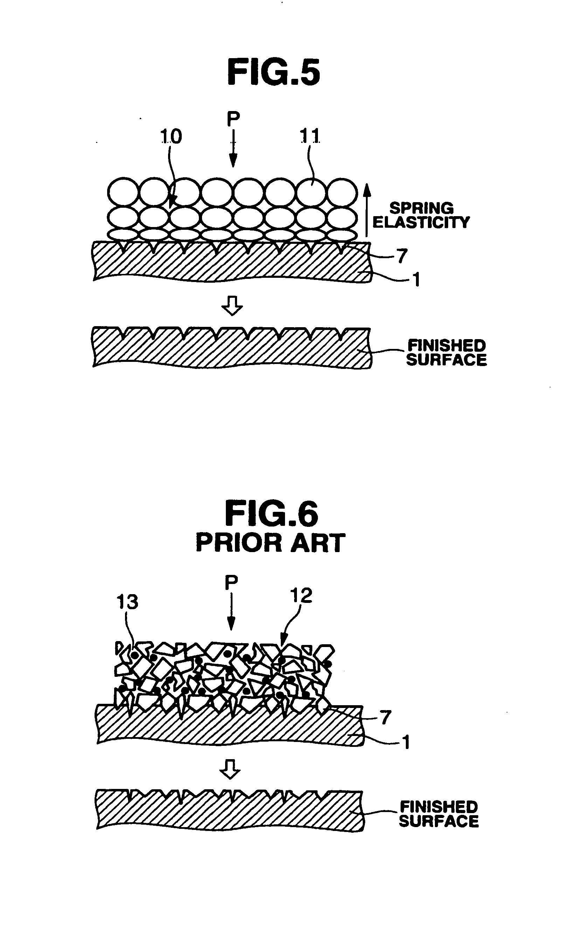

Specifically, reference is made to an example wherein an elastic abrasive member is used, and particularly wherein an elastic abrasive member made of porous synthetic resin is used. As shown in FIG. 5, the surface of a plate 1 is lapped while pressing the plate resurfacing abrasive member (elastic abrasive member) 10 downward and feeding loose abrasive grains 7. When pressure P is applied while feeding loose abrasive grains 7 in between the plate 1 and the elastic abrasive member 10, the elastic abrasive member exhibits spring elasticity due to microscopic cells 11 contained in the elastic abrasive member 10 structure. As a result, the plate is provided with a rough surface having a uniform and higher roughness, independent of any variations of the applied pressure. In contrast, as shown in FIG. 6, a non-elastic vitrified abrasive member or resinoid bonded abrasive member 12 consisting of abrasive grains bonded with a binder 13 contains no pores in the interior and lacks spring elasticity because of the absence of cells. As a result, a surface having a uniform roughness is not readily obtained and the resulting roughness is relatively low.

As discussed above, when the plate is reconditioned according to the invention, the surface of the plate 1 is roughened to an appropriate roughness as compared with the use of conventional plate-dressing jigs. As shown in FIG. 3, loose abrasive grains 7 are effectively captured within raised and recessed portions 8 on the roughened surface of the plate 1, preventing the grains from popping and falling out of the plate surface. This allows, during the lapping of a workpiece 6, loose abrasive grains to exert a lapping force. As a result, the workpiece can be lapped within a short time and the amount of loose abrasive grains used in the lapping be reduced.

### EXAMPLE

Examples of the invention are given below by way of illustration and not by way of limitation.

### Example I and Comparative Example I

The lapping machine used was a 4-way double-sided lapping machine, Model 15B by Fujikoshi Machinery Corp. First, for the upper and lower lapping plates, surface dressing was carried out by the following method and under the following conditions, using dressing rings.
Plate:
   Material: spheroidal-graphite cast iron
   Size: 15B
Dressing ring:
   Material: same as the plates
   Number: 4
   Size: 380 mm diameter
Dressing method and conditions:
   Lapping load: 100 g/cm²
   Lower plate rotation: 65 rpm
   Upper plate rotation: 21.5 rpm
   Loose abrasive grains: FO #1200
   Abrasive slurry: 20% dispersion
   Abrasive slurry feed rate: 180 cc/min
   Lapping time: 30 min

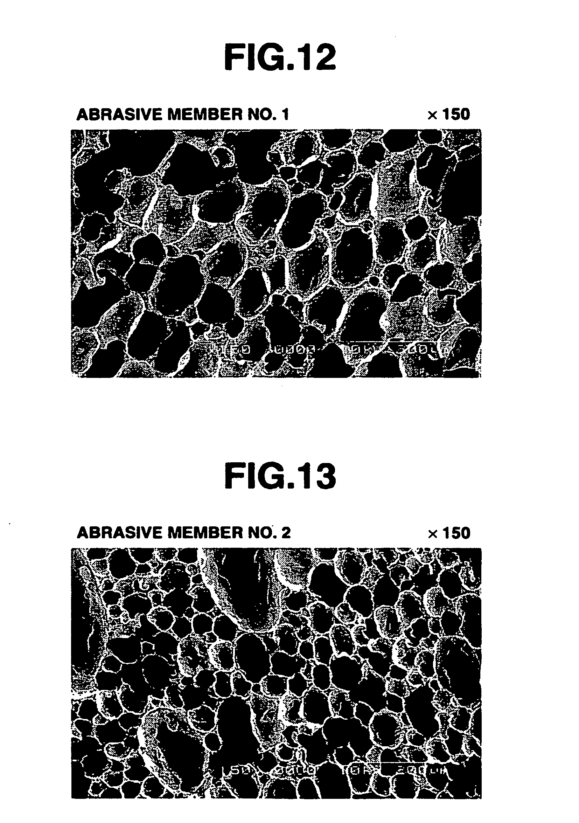

After the upper and lower plates were surface-dressed with the dressing rings, the upper and lower plates were resurfaced by the following method and under the following conditions, using plate resurfacing abrasive members as described below.
Plate resurfacing abrasive member No. 1 (see FIG. 12):
   Shape and size: 150 mm diameter disks
   Number: 12
   Material: polyurethane
   cells: 100 µm diameter
   Rockwell hardness: -80
   Bulk density: 0.5 g/cm³
Plate resurfacing abrasive member No. 2 (see FIG. 13):
   Shape and size: 150 mm diameter disks
   Number: 12
   Material: polyurethane
   cells: 50 µm diameter
   Rockwell hardness: -70
   Bulk density: 0.6 g/cm³
Regulatory carrier:
   Material: cast iron (same as the plates)
   Number: 4
   Size: 380 mm diameter
Resurfacing method and conditions:
   same as the plate dressing method using dressing rings
   Lapping load: 100 g/cm²
   Lower plate rotation: 65 rpm
   Upper plate rotation: 21.5 rpm
   Loose abrasive grains: FO #1200
   Abrasive slurry: 20% dispersion
   Abrasive slurry feed rate: 180 cc/min
   Lapping time: 30 min

After the plates were dressed or resurfaced as described above, the plates were measured for surface roughness, data of which are shown in Table 1.

**Table 1**

| | Dressing ring | | Abrasive member No. 1 | | Abrasive member No. 2 | |
|---|---|---|---|---|---|---|
| | Ra | Rz | Ra | Rz | Ra | Rz |
| After dressing or resurfacing | 0.21 | 2.68 | 0.52 | 4.81 | 0.37 | 5.27 |

| | | | | | | |
|---|---|---|---|---|---|---|
| Ra: center line average roughness Rz: ten-point average roughness Surface roughness: JIS B0601 | | | | | | |

It is noted that the dressing operation using dressing rings was successful in flattening the plate surface. By contrast, in the processing using the resurfacing abrasive member, the flat state of the plate surface remained substantially unchanged before and after the processing, suggesting that the resurfacing abrasive member does not have a function of flattening and dressing irregularities on the plate surface.

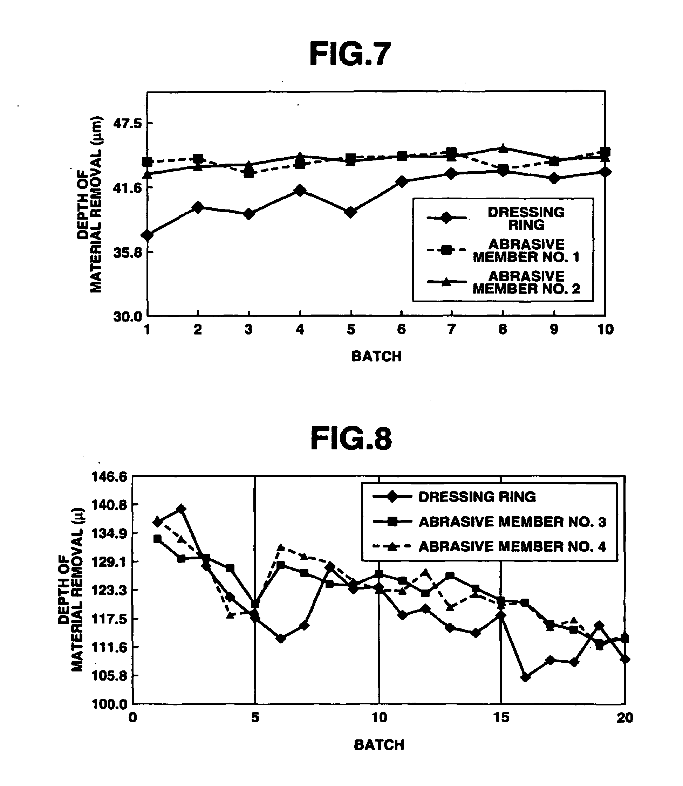

Next, using the plates whose surface was dressed by the dressing rings and the plates whose surface was resurfaced by resurfacing abrasive member Nos. 1 and 2, silicon wafers were repeatedly lapped under the following conditions and by the same method as shown in FIG. 1. The results are shown in Tables 2 to 4 and FIG. 7.
Workpiece: silicon wafer
Workpiece size: 31.4 cm²
Number of workpieces per batch: 35
Lapping time per batch: 10 min
Recycle: yes
Upper plate rotation: 21.5 rpm
Lower plate rotation: 65 rpm
Load: 100 g/cm²
Abrasive slurry: 20 wt% dispersion
Anti-rust agent: 1%
Abrasive slurry feed rate: 180 ml/min
Abrasive grains: FO #1200
Abrasive member size: 151 × 40 × 50
Carrier material: vinyl chloride resin
Carrier size: 380 mm diameter
Workpieces on carrier: seven 4-inch silicon wafers
Number of carriers: 5

**Table 2: Dressing ring**

| Batch No. | Workpiece thickness before lapping | Workpiece thickness after lapping | Depth of material removal (µm) |
|---|---|---|---|
| 1 | 542.5 | 505.2 | 37.3 |
| 2 | 542.5 | 502.6 | 39.9 |
| 3 | 542.1 | 502.9 | 39.2 |
| 4 | 542.0 | 500.7 | 41.3 |
| 5 | 541.9 | 502.6 | 39.3 |
| 6 | 542.1 | 500.1 | 42.0 |
| 7 | 542.1 | 499.4 | 42.7 |
| 8 | 542.3 | 499.3 | 43.0 |
| 9 | 543.1 | 500.8 | 42.3 |
| 10 | 542.3 | 499.5 | 42.8 |
| | | Standard deviation | 1.9 |
| | | Total depth of material removal | 409.8 |

**Table 3: Abrasive member No. 1**

| Batch No. | Workpiece thickness before lapping | Workpiece thickness after lapping | Depth of material removal (µm) |
|---|---|---|---|
| 1 | 538.1 | 494.3 | 43.8 |
| 2 | 538.0 | 493.9 | 44.1 |
| 3 | 538.1 | 495.3 | 42.8 |
| 4 | 538.3 | 494.7 | 43.6 |
| 5 | 538.1 | 494.0 | 44.1 |
| 6 | 539.0 | 494.8 | 44.2 |
| 7 | 538.5 | 493.9 | 44.6 |
| 8 | 537.0 | 493.9 | 43.1 |
| 9 | 537.1 | 493.4 | 43.7 |
| 10 | 537.2 | 492.7 | 44.5 |
| | | Standard deviation | 0.5 |
| | | Total depth of material removal | 438.5 |

**Table 4: Abrasive member No. 2**

| Batch No. | Workpiece thickness before lapping | Workpiece thickness after lapping | Depth of material removal (µm) |
|---|---|---|---|
| 1 | 536.6 | 493.9 | 42.7 |
| 2 | 538.3 | 494.8 | 43.5 |
| 3 | 537.4 | 493.7 | 43.7 |
| 4 | 537.6 | 493.3 | 44.3 |
| 5 | 537.5 | 493.5 | 44.0 |
| 6 | 537.1 | 492.8 | 44.3 |
| 7 | 537.4 | 493.1 | 44.3 |
| 8 | 537.7 | 492.8 | 44.9 |
| 9 | 537.3 | 493.3 | 44.0 |
| 10 | 537.5 | 493.4 | 44.1 |
| | | Standard deviation | 0.6 |
| | | Total depth of material removal | 439.8 |

### Example II and Comparative Example II

The lapping machine used was a 4-way double-sided lapping machine, Model 6B by Fujikoshi Machinery Corp. First, for the upper and lower lapping plates, surface dressing was carried out by the following method and under the following conditions, using dressing rings.
Plate:
   Material: spheroidal-graphite cast iron
   Size: 6B
Dressing ring:
   Material: same as the plates
   Number: 4
   Size: 150 mm diameter
Dressing method and conditions:
   Lapping load: 100 g/cm²
   Lower plate rotation: 60 rpm
   Upper plate rotation: 20 rpm
   Loose abrasive grains: GC #1500
   Abrasive slurry: 25% dispersion
   Abrasive slurry feed rate: 500 cc/min
   Lapping time: 30 min

After the upper and lower plates were surface-dressed with the dressing rings, the upper and lower plates were resurfaced by the following method and under the following conditions, using plate resurfacing abrasive members as described below.
Plate resurfacing abrasive member No. 3:
   Shape and size: 120 mm diameter disks
   Number: 4
   Material: polyvinyl acetal and melamine resins
   cells: 60 µm diameter
   Rockwell hardness: -60
   Bulk density: 0.7 g/cm³
Plate resurfacing abrasive member No. 4:
   Shape and size: 120 mm diameter disks
   Number: 4
   Material: polyurethane
   cells: 100 µm diameter
   Rockwell hardness: -80
   Bulk density: 0.5 g/cm³
Regulatory carrier:
   Material: cast iron (same as the plates)
   Number: 4
   Size: 150 mm diameter
Resurfacing method and conditions:
   same as the plate dressing method using dressing rings
   Lapping load: 100 g/cm²
   Lower plate rotation: 60 rpm
   Upper plate rotation: 20 rpm
   Loose abrasive grains: GC #1500
   Abrasive slurry: 25% dispersion
   Abrasive slurry feed rate: 500 cc/min
   Lapping time: 30 min

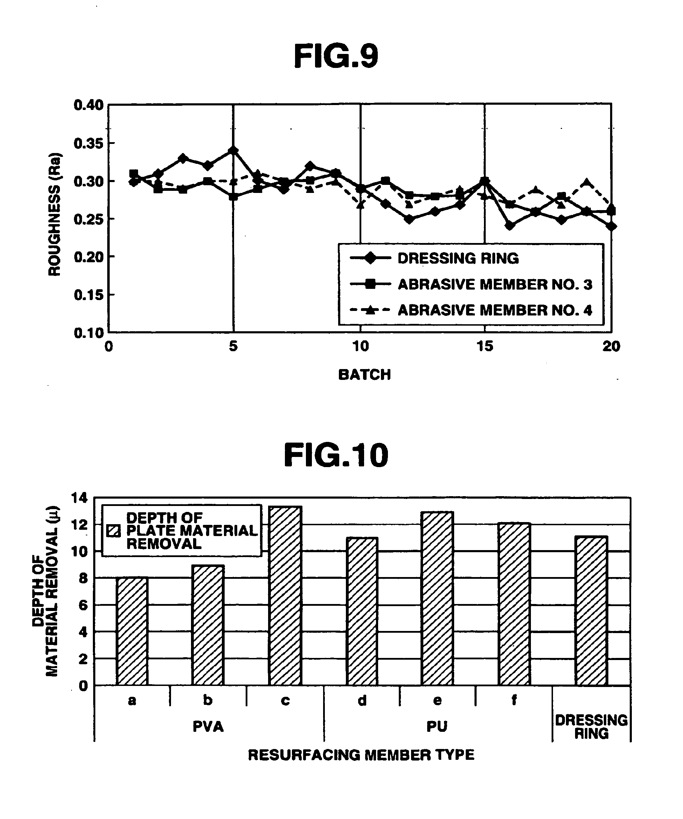

Next, using the plates whose surface was dressed by the dressing rings and the plates whose surface was resurfaced by resurfacing abrasive member Nos. 3 and 4, synthetic quartz glass substrates were repeatedly lapped under the following conditions and by the same method as shown in FIG. 1. The results are shown in Tables 5 to 7 and FIGS. 8 and 9.
Workpiece: synthetic quartz glass
Workpiece size: 76 mm × 76 mm
Number of workpieces per batch: 6
Lapping time per batch: 10 min
Recycle: yes
Plate size: 6B
Upper plate rotation: 20 rpm
Lower plate rotation: 60 rpm
Load: 100 g/cm²
Abrasive slurry: 25 wt% dispersion
Anti-rust agent: 1%
Abrasive slurry feed rate: 500 ml/min
Abrasive grains: GC #1500
Carrier material: vinyl chloride resin
Carrier size: 150 mm diameter
Number of carriers: 6

**Table 5: Dressing ring**

| Batch No. | Workpiece thickness before lapping | Workpiece thickness after lapping | Depth of material removal (µm) | Weight before lapping (g) | Weight after lapping (g) | Weight loss (g) | Surface roughness | |
|---|---|---|---|---|---|---|---|---|
| | | | | | | | Ra | Rz |
| 1 | 2189.0 | 2051.5 | 137.5 | 165.6 | 155.3 | 10.3 | 0.30 | 2.41 |
| 2 | 2190.6 | 2050.6 | 140.0 | 165.3 | 155.1 | 10.2 | 0.31 | 2.43 |
| 3 | 1751.8 | 1623.8 | 128.0 | 132.7 | 122.5 | 10.2 | 0.33 | 2.37 |
| 4 | 1751.6 | 1629.7 | 121.9 | 132.7 | 123.0 | 9.7 | 0.32 | 2.24 |
| 5 | 1749.8 | 1632.1 | 117.7 | 132.8 | 123.3 | 9.5 | 0.34 | 2.34 |
| 6 | 2051.5 | 1938.0 | 113.5 | 155.3 | 146.4 | 8.9 | 0.30 | 2.27 |
| 7 | 2050.6 | 1934.6 | 116.0 | 155.1 | 146.1 | 9.0 | 0.29 | 2.17 |
| 8 | 1623.8 | 1496.1 | 127.7 | 122.5 | 112.9 | 9.6 | 0.32 | 2.34 |
| 9 | 1629.7 | 1506.3 | 123.4 | 123.0 | 113.7 | 9.3 | 0.31 | 2.08 |
| 10 | 1632.1 | 1508.0 | 124.1 | 123.3 | 114.1 | 9.2 | 0.29 | 2.03 |
| 11 | 1938.0 | 1819.8 | 118.2 | 146.4 | 138.0 | 8.4 | 0.27 | 1.90 |
| 12 | 1934.6 | 1814.8 | 119.8 | 146.1 | 137.3 | 8.8 | 0.25 | 2.01 |
| 13 | 1496.1 | 1380.5 | 115.6 | 112.9 | 104.3 | 8.6 | 0.26 | 1.80 |
| 14 | 1506.3 | 1391.8 | 114.5 | 113.7 | 105.1 | 8.6 | 0.27 | 2.27 |
| 15 | 1508.0 | 1389.8 | 118.2 | 114.1 | 105.2 | 8.9 | 0.30 | 2.04 |
| 16 | 1819.8 | 1714.6 | 105.2 | 138.0 | 130.2 | 7.8 | 0.24 | 1.96 |
| 17 | 1814.8 | 1705.8 | 109.0 | 137.3 | 129.4 | 7.9 | 0.26 | 1.84 |
| 18 | 1380.5 | 1271.8 | 108.7 | 104.3 | 96.2 | 8.1 | 0.25 | 1.99 |
| 19 | 1391.8 | 1275.8 | 116.0 | 105.1 | 96.7 | 8.4 | 0.26 | 1.87 |
| 20 | 1389.8 | 1280.5 | 109.3 | 105.2 | 96.7 | 8.5 | 0.24 | 1.83 |
| | Standard deviation | | 8.9 | Standard deviation | | 0.7 | | |
| | Total depth of material removal | | 2384 | Total weight loss | | 179.9 | | |

**Table 6: Abrasive member No. 3**

| Batch No. | Workpiece thickness before lapping | Workpiece thickness after lapping | Depth of material removal (µm) | Weight before lapping (g) | Weight after lapping (g) | Weight loss (g) | Surface roughness | |
|---|---|---|---|---|---|---|---|---|
| | | | | | | | Ra | Rz |
| 1 | 1715.5 | 1581.5 | 134.0 | 130.1 | 119.7 | 10.4 | 0.31 | 2.47 |
| 2 | 1706.1 | 1576.5 | 129.6 | 129.4 | 119.4 | 10.0 | 0.29 | 2.23 |
| 3 | 1751.6 | 1621.8 | 129.8 | 132.8 | 122.7 | 10.1 | 0.29 | 2.34 |
| 4 | 1745.6 | 1618.0 | 127.6 | 132.1 | 122.4 | 9.7 | 0.30 | 2.31 |
| 5 | 1734.8 | 1614.3 | 120.5 | 131.6 | 122.1 | 9.5 | 0.28 | 2.28 |
| 6 | 1581.5 | 1453.0 | 128.5 | 119.7 | 110.2 | 9.5 | 0.29 | 2.23 |
| 7 | 1576.5 | 1449.8 | 126.7 | 119.4 | 110.0 | 9.4 | 0.30 | 2.03 |
| 8 | 1621.8 | 1497.3 | 124.5 | 122.7 | 113.4 | 9.3 | 0.30 | 2.04 |
| 9 | 1618.0 | 1493.8 | 124.2 | 122.4 | 112.8 | 9.6 | 0.31 | 2.29 |
| 10 | 1614.3 | 1487.8 | 126.5 | 122.1 | 112.5 | 9.6 | 0.29 | 2.36 |
| 11 | 1453.0 | 1327.8 | 125.2 | 110.2 | 100.6 | 9.6 | 0.30 | 2.07 |
| 12 | 1449.8 | 1327.3 | 122.5 | 110.0 | 100.5 | 9.5 | 0.28 | 2.07 |
| 13 | 1497.3 | 1371.1 | 126.2 | 113.4 | 103.6 | 9.8 | 0.28 | 2.10 |
| 14 | 1493.8 | 1370.3 | 123.5 | 112.8 | 103.5 | 9.3 | 0.28 | 2.18 |
| 15 | 1487.8 | 1366.8 | 121.0 | 112.5 | 103.1 | 9.4 | 0.30 | 2.12 |
| 16 | 1327.8 | 1207.1 | 120.7 | 100.6 | 91.1 | 9.5 | 0.27 | 1.98 |
| 17 | 1327.3 | 1211.0 | 116.3 | 100.5 | 91.6 | 8.9 | 0.26 | 2.09 |
| 18 | 1371.1 | 1256.1 | 115.0 | 103.6 | 94.9 | 8.7 | 0.28 | 2.02 |
| 19 | 1370.3 | 1257.8 | 112.5 | 103.5 | 95.0 | 8.5 | 0.26 | 1.81 |
| 20 | 1366.8 | 1253.3 | 113.5 | 103.1 | 94.6 | 8.5 | 0.26 | 1.87 |
| | Standard deviation | | 5.6 | Standard deviation | | 0.5 | | |
| | Total depth of material removal | | 2468.3 | Total weight loss | | 188.8 | | |

**Table 7: Abrasive member No. 4**

| Batch No. | Workpiece thickness before lapping | Workpiece thickness after lapping | Depth of material removal (µm) | Weight before lapping (g) | Weight after lapping (g) | Weight loss (g) | Surface roughness | |
|---|---|---|---|---|---|---|---|---|
| | | | | | | | Ra | Rz |
| 1 | 1738.5 | 1600.5 | 138.0 | 131.7 | 121.1 | 10.6 | 0.30 | 2.34 |
| 2 | 1743.3 | 1610.3 | 133.0 | 131.8 | 121.6 | 10.2 | 0.30 | 2.30 |
| 3 | 1740.1 | 1611.1 | 129.0 | 131.7 | 121.7 | 10.0 | 0.29 | 2.23 |
| 4 | 1727.5 | 1609.3 | 118.2 | 130.9 | 121.4 | 9.5 | 0.30 | 2.05 |
| 5 | 1730.0 | 1610.8 | 119.2 | 130.8 | 121.5 | 9.3 | 0.30 | 2.13 |
| 6 | 1600.5 | 1468.5 | 132.0 | 121.1 | 110.9 | 10.2 | 0.31 | 2.29 |
| 7 | 1610.3 | 1480.1 | 130.2 | 121.6 | 111.8 | 9.8 | 0.30 | 2.14 |
| 8 | 1611.1 | 1482.5 | 128.6 | 121.7 | 112.1 | 9.6 | 0.29 | 2.20 |
| 9 | 1609.3 | 1484.1 | 125.2 | 121.4 | 112.0 | 9.4 | 0.30 | 2.10 |
| 10 | 1610.8 | 1487.5 | 123.3 | 121.5 | 112.2 | 9.3 | 0.27 | 2.24 |
| 11 | 1468.5 | 1345.6 | 122.9 | 110.9 | 101.8 | 9.1 | 0.30 | 2.09 |
| 12 | 1480.1 | 1353.1 | 127.0 | 111.8 | 102.2 | 9.6 | 0.27 | 2.13 |
| 13 | 1482.5 | 1363.0 | 119.5 | 112.1 | 102.8 | 9.3 | 0.28 | 2.01 |
| 14 | 1484.1 | 1361.8 | 122.3 | 112.0 | 102.8 | 9.2 | 0.29 | 1.98 |
| 15 | 1487.5 | 1367.6 | 119.9 | 112.2 | 103.1 | 9.1 | 0.28 | 1.93 |
| 16 | 1345.6 | 1225.0 | 120.6 | 101.8 | 92.5 | 9.3 | 0.27 | 2.04 |
| 17 | 1353.1 | 1237.5 | 115.6 | 102.2 | 93.4 | 8.8 | 0.29 | 1.86 |
| 18 | 1363.0 | 1246.0 | 117.0 | 102.8 | 94.1 | 8.7 | 0.27 | 1.94 |
| 19 | 1361.8 | 1250.1 | 111.7 | 102.8 | 94.2 | 8.6 | 0.30 | 2.10 |
| 20 | 1367.6 | 1253.5 | 114.1 | 103.1 | 94.6 | 8.5 | 0.27 | 2.05 |
| | Standard deviation | | 6.7 | Standard deviation | | 0.5 | | |
| | Total depth of material removal | | 2467.3 | Total weight loss | | 188.1 | | |

### Reference Example

The lapping machine used was a 4-way double-sided lapping machine, Model 6B by Fujikoshi Machinery Corp. The surface of the upper and lower lapping plates was processed by the following method and under the following conditions, using dressing rings or abrasive members.
Plate:
   Material: spheroidal-graphite cast iron
   Size: 6B
Dressing ring:
   Material: same as the plates
   Number: 4
   Size: 150 mm diameter
Abrasive member PVA:
   (a) polyvinyl acetal/melamine resin abrasive member with abrasive grains GC having 8 µm diameter
      Shape and size: 120 mm diameter
      Number: 4
      Cells: 30 µm diameter
      Rockwell hardness: -70
      Bulk density: 0.60 g/cm³
   (b) polyvinyl acetal/melamine resin abrasive member with abrasive grains GC having 14 µm diameter
      Shape and size: 120 mm diameter
      Number: 4
      Cells: 60 µm diameter
      Rockwell hardness: -60
      Bulk density: 0.65 g/cm³
   (c) polyvinyl acetal/melamine resin abrasive member with abrasive grains GC having 25 µm diameter
      Shape and size: 120 mm diameter
      Number: 4
      Cells: 40 µm diameter
      Rockwell hardness: -50
      Bulk density: 0.70 g/cm³
Abrasive member PU:
   (d) polyurethane abrasive member with abrasive grains C having 8 µm diameter
      Shape and size: 120 mm diameter
      Number: 4
      Cells: 100 µm diameter
      Rockwell hardness: -80
      Bulk density: 0.50 g/cm³
   (e) polyurethane abrasive member with abrasive grains C having 8 µm diameter
      Shape and size: 120 mm diameter
      Number: 4
      Cells: 100 µm diameter
      Rockwell hardness: -90
      Bulk density: 0.45 g/cm³
   (f) polyurethane abrasive member with abrasive grains C having 6.5 µm diameter
      Shape and size: 120 mm diameter
      Number: 4
      Cells: 80 µm diameter
      Rockwell hardness: -80
      Bulk density: 0.50 g/cm³
Processing method and conditions:
   Lapping load: 100 g/cm²
   Lower plate rotation: 60 rpm
   Upper plate rotation: 20 rpm
   Abrasive grains: GC #1500
   Abrasive slurry: 25% dispersion
   Abrasive slurry feed rate: 500 cc/min
   Lapping time: 30 min

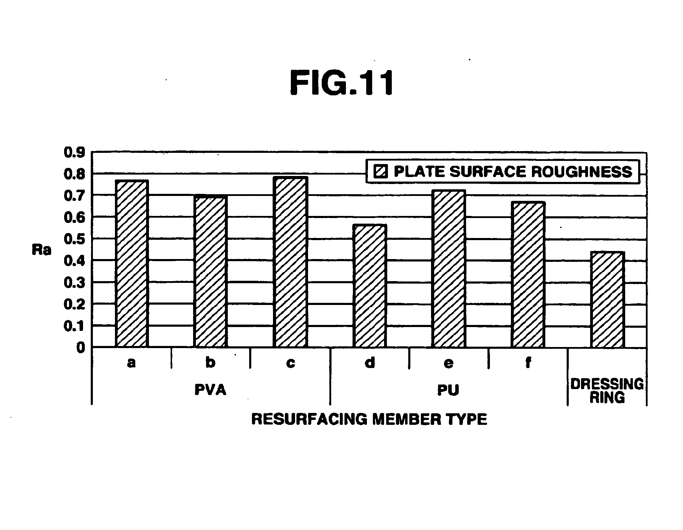

The plates thus processed were measured for depth of material removal and surface roughness, with the results shown in Table 8 and FIGS. 10 and 11.

**Table 8**

| Abrasive members type | Plate, depth of removal (µm) | Abrasive member, wear (µm) | Plate surface roughness | |
|---|---|---|---|---|
| | | | Ra | Rz |
| PVA-a | 7.9 | 3667.5 | 0.77 | 3.84 |
| PVA-b | 8.9 | 4735 | 0.69 | 3.36 |
| PVA-c | 13.3 | 2512.5 | 0.78 | 4.35 |
| PU-d | 10.9 | 5382.5 | 0.56 | 3.84 |
| PU-e | 12.9 | 6480 | 0.72 | 5.49 |
| PU-f | 12.1 | 6565 | 0.67 | 3.76 |
| Dressing ring | 11.1 | | 0.44 | 3.82 |

## Claims

1. Lapping apparatus comprising a lapping machine with a lapping plate and a workpiece carrier disposed on the plate, wherein in use a workpiece is held at a workpiece-holding recess of the carrier and lapped while the plate and the carrier are individually rotated and abrasive grains are fed onto the plate, the apparatus further comprising an abrasive member for conditioning the surface of the lapping plate, **characterised in that** the abrasive member is a synthetic resin-based elastic abrasive member having a Rockwell hardness (HRS) in the range of -30 to -100.

2. Apparatus of claim 1 wherein the synthetic resin-based elastic abrasive member is porous.

3. Apparatus of claim 2 wherein the elastic abrasive member is a polyurethane or polyvinyl acetal-based abrasive member having a plurality of microscopic cells.

4. Apparatus of claim 1, 2 or 3 wherein the elastic abrasive member has a bulk density of 0.4 to 0.9 g/cm³.

5. Apparatus of any one of claims 1 to 4 wherein the elastic abrasive member has abrasive grains dispersed and bound therein.

6. Apparatus according to any one of claims 1 to 5, wherein the lapping plate is made from spheroidal-graphite cast iron.

7. A method of conditioning the lapping surface of a lapping plate, comprising lapping the plate's surface using loose abrasive grains and an abrasive member as defined in any one of claims 1 to 6.

8. A method for resurfacing a lapping plate, comprising the steps of:
placing a resurfacing carrier with a holding recess on the lapping plate, holding within the carrier recess a synthetic resin-based elastic abrasive member having a Rockwell hardness (HRS) in the range of -30 to -100,
rotating the plate and the carrier individually, and
feeding loose abrasive grains onto the plate,
for thereby lapping the surface of the plate with the elastic abrasive member for roughening the plate surface in accordance with the coarseness of the abrasive grains.

9. A plate resurfacing method of claim 8 wherein the synthetic resin-based elastic abrasive member is porous.

10. A plate resurfacing method of claim 9 wherein the elastic abrasive member is a polyurethane or polyvinyl acetal-based abrasive member having a plurality of microscopic cells.

11. A plate resurfacing method of any one of claims 8 to 10 wherein the elastic abrasive member has a bulk density of 0.4 to 0.9 g/cm³.

12. A plate resurfacing method of any one of claims 8 to 11 wherein the elastic abrasive member has abrasive grains dispersed and bound therein.

13. A lapping method in which workpieces are lapped on a lapping machine, having a lapping plate and a workpiece carrier to hold the workpieces against the lapping plate, the method comprising rotation of the lapping plate and workpiece carrier and feeding of abrasive grains onto the lapping plate, with occasional conditioning of the lapping plate to roughen its surface using an abrasive member, **characterised in that** the abrasive member is in accordance with claim 6.

14. Lapping method of claim 13 wherein the conditioning by the abrasive member uses abrasive grains which are the same as the abrasive grains fed onto the lapping plate for the lapping of the workpieces.

15. A lapping method of claim 13 or 14 wherein the conditioning includes a step of flattening the plate surface before use of said abrasive member.

16. A lapping method of claim 13, 14 or 15 wherein the workpieces are silicon wafers, synthetic quartz glass, rock crystal, liquid crystal glass, or ceramics.

17. A method according to any one of claims 13 to 16, wherein the lapping plate is made from spheroidal-graphite cast iron.

## Patentansprüche

1. Läppvorrichtung, umfassend eine Läppmaschine mit einer Läppscheibe und einem auf der Scheibe angeordneten Werkstückträger, wobei bei Betrieb ein Werkstück an einer Werkstück-Haltevertiefung des Trägers gehalten wird und geläppt wird, während die Scheibe und der Träger einzeln gedreht werden und Schleifkörner auf die Scheibe zugeführt werden, wobei die Vorrichtung ferner ein Schleifelement zur Bearbeitung der Oberfläche der Läppscheibe umfasst, **dadurch gekennzeichnet, dass** das Schleifelement ein elastisches Schleifelement auf Kunstharzbasis mit einer Rockwellhärte (HRS) im Bereich von -30 bis -100 ist.

2. Vorrichtung nach Anspruch 1, worin das elastische Schleifelement auf Kunstharzbasis porös ist.

3. Vorrichtung nach Anspruch 1, worin das elastische Schleifelement ein Schleifelement auf Polyurethan- oder Polyvinylacetalbasis mit einer Vielzahl mikroskopischer Zellen ist.

4. Vorrichtung nach Anspruch 1, 2 oder 3, worin das elastische Schleifelement eine Schüttdichte von 0,4 bis 0,9 g/cm³ aufweist.

5. Vorrichtung nach einem der Ansprüche 1 bis 4, worin das elastische Schleifelement darin dispergierte und gebundene Schleifkörner aufweist.

6. Vorrichtung nach einem der Ansprüche 1 bis 5, worin die Läppscheibe aus Gusseisen mit Kugelgraphit hergestellt wurde.

7. Verfahren zur Bearbeitung der Läppoberfläche einer Läppscheibe, umfassend das Läppen der Oberfläche der Scheibe unter Einsatz loser Schleifkörner und eines Schleifelements wie in einem der Ansprüche 1 bis 6 definiert.

8. Verfahren zur Oberflächenerneuerung einer Läppscheibe, das folgende Schritte umfasst:
das Platzieren eines Oberflächenerneuerungsträgers mit einer Haltevertiefung auf der Läppscheibe, wobei in der Haltevertiefung ein elastisches Schleifelement auf Kunstharzbasis mit einer Rockwellhärte (HRS) im Bereich von -30 bis -100 gehalten wird,
das einzelne Drehen der Scheibe und des Trägers und
das Zuführen loser Schleifkörner auf die Scheibe,
wodurch die Oberfläche der Scheibe mit dem elastischen Schleifelement zum Aufrauen der Scheibenoberfläche gemäß der Grobheit der Schleifkörner geläppt wird.

9. Verfahren zur Oberflächenerneuerung nach Anspruch 8, worin das elastische Schleifelement auf Kunstharzbasis porös ist.

10. Verfahren zur Oberflächenerneuerung nach Anspruch 9, worin das elastische Schleifelement ein Schleifelement auf Polyurethan- oder Polyvinylacetalbasis mit einer Vielzahl an mikroskopischen Zellen ist.

11. Verfahren zur Oberflächenerneuerung nach einem der Ansprüche 8 bis 10, worin das elastische Schleifelement eine Schüttdichte von 0,4 bis 0,9 g/cm³ aufweist.

12. Scheibenoberflächenerneuerungsverfahren nach einem der Ansprüche 8 bis 11, worin das elastische Schleifelement darin dispergierte und gebundene Schleifkörner aufweist.

13. Läppverfahren, in dem Werkstücke auf einer Läppmaschine mit einer Läppscheibe und einem Werkstückträger zum Halten der Werkstücke gegen die Läppscheibe geläppt werden, wobei das Verfahren das Drehen der Läppscheibe und des Werkstückträgers und das Zuführen von Schleifkörnern auf die Läppscheibe umfasst, wobei die Läppscheibe gelegentlich bearbeitet wird, um ihre Oberfläche unter Einsatz eines Schleifelements aufzurauen, **dadurch gekennzeichnet, dass** das Schleifelement ein Schleifelement nach Anspruch 6 ist.

14. Läppverfahren nach Anspruch 13, worin für die Bearbeitung durch das Schleifelement Schleifkörner eingesetzt werden, die den auf die Läppscheibe zum Läppen des Werkstücks zugeführten Schleifkörnern entsprechen.

15. Läppverfahren nach Anspruch 13 oder 14, worin das Bearbeiten einen Schritt des Glättens der Scheibenoberfläche vor dem Einsatz des Schleifelements umfasst.

16. Läppverfahren nach Anspruch 13, 14, oder 15, worin die Werkstücke Siliciumwafer, synthetisches Quarzglas, Bergkristall, Flüssigkristallglas oder Keramikmaterial sind.

17. Verfahren nach einem der Ansprüche 13 bis 16, worin die Läppscheibe aus Gusseisen mit Kugelgraphit hergestellt wurde.

## Revendications

1. Dispositif de rodage comprenant une machine à roder comportant une plaque de rodage et un support de pièce de fabrication disposé sur la plaque, dans lequel, en utilisation, une pièce de fabrication est maintenue au niveau d'un évidement de maintien de pièce de fabrication du support et rodée tandis que la plaque et le support sont mis en rotation individuellement et que des grains abrasifs sont délivrés sur la plaque, le dispositif comprenant en outre un élément abrasif pour conditionner la surface de la plaque de rodage, **caractérisé en ce que** l'élément abrasif est un élément abrasif élastique à base de résine synthétique ayant une dureté Rockwell (HRS) dans la plage de -30 à -100.

2. Dispositif selon la revendication 1, dans lequel l'élément abrasif élastique à base de résine synthétique est poreux.

3. Dispositif selon la revendication 2, dans lequel l'élément abrasif élastique est un élément abrasif à base de polyuréthane ou de polyacétal de vinyle comportant une pluralité de cellules microscopiques.

4. Dispositif selon la revendication 1, 2 ou 3, dans lequel l'élément abrasif élastique a une masse volumique de 0,4 à 0, 9 g/cm³.

5. Dispositif selon l'une quelconque des revendications 1 à 4, dans lequel l'élément abrasif élastique contient dans celui-ci des grains abrasifs dispersés et liés.

6. Dispositif selon l'une quelconque des revendications 1 à 5, dans lequel la plaque de rodage est réalisée en fonte à graphite sphéroïdal.

7. Procédé de conditionnement de la surface de rodage d'une plaque de rodage, comprenant le rodage de la surface de la plaque en utilisant des grains abrasifs en vrac et un élément abrasif tel que défini dans l'une quelconque des revendications 1 à 6.

8. Procédé pour rectifier une plaque de rodage, comprenant les étapes consistant à :
placer un support de rectification comportant un évidement de maintien sur la plaque de rodage, maintenir dans l'évidement de support un élément abrasif élastique à base de résine synthétique ayant une dureté Rockwell (HRS) dans la plage de -30 à -100,
faire tourner la plaque et le support individuellement, et
délivrer des grains abrasifs en vrac sur la plaque,
pour de ce fait roder la surface de la plaque avec l'élément abrasif élastique pour rugosifier la surface de la plaque conformément à la grosseur de grain des grains abrasifs.

9. Procédé de rectification de plaque selon la revendication 8, dans lequel l'élément abrasif élastique à base de résine synthétique est poreux.

10. Procédé de rectification de plaque selon la revendication 9, dans lequel l'élément abrasif élastique est un élément abrasif à base de polyuréthane ou de polyacétal de vinyle comportant une pluralité de cellules microscopiques.

11. Procédé de rectification de plaque selon l'une quelconque des revendications 8 à 10, dans lequel l'élément abrasif élastique a une masse volumique de 0,4 à 0,9 g/cm³.

12. Procédé de rectification de plaque selon l'une quelconque des revendications 8 à 11, dans lequel l'élément abrasif élastique contient dans celui-ci des grains abrasifs dispersés et liés.

13. Procédé de rodage dans lequel des pièces de fabrication sont rodées sur une machine à roder, comportant une plaque de rodage et un support de pièce de fabrication pour maintenir les pièces de fabrication contre la plaque de rodage, le procédé comprenant la mise en rotation de la plaque de rodage et du support de pièce de fabrication et la distribution de grains abrasifs sur la plaque de rodage, avec un conditionnement occasionnel de la plaque de rodage pour rugosifier sa surface en utilisant un élément abrasif, **caractérisé en ce que** l'élément abrasif est selon la revendication 6.

14. Procédé de rodage selon la revendication 13, dans lequel le conditionnement par l'élément abrasif utilise des grains abrasifs qui sont identiques aux grains abrasifs délivrés sur la plaque de rodage pour le rodage des pièces de fabrication.

15. Procédé de rodage selon la revendication 13 ou 14, dans lequel le conditionnement comprend une étape d'égalisation de la surface de la plaque avant l'utilisation dudit élément abrasif.

16. Procédé de rodage selon la revendication 13, 14 ou 15, dans lequel les pièces de fabrication sont des tranches de silicium, du verre de quartz synthétique, du cristal de roche, du verre à cristaux liquides, ou une céramique.

17. Procédé selon l'une quelconque des revendications 13 à 16, dans lequel la plaque de rodage est réalisée en fonte à graphite sphéroïdal.
